# EUROPEAN PATENT APPLICATION

(11) **EP 4 773 507 A1**
(43) Date of publication of application: **08.07.2026**
(21) Application number: 25227867.6
(22) Date of filing: 31.12.2025
(51) Int. Cl.: H03K 3/037, H03K 3/3562, H03K 3/012

(54) **FLIP-FLOP FOR REDUCING SETUP TIME**

(30) Priority: 02.01.2025 KR 20250000475
(71) Applicant: Samsung Electronics Co., Ltd., Suwon-si, Gyeonggi-do 16677 (KR)
(72) Inventor: JOO, Bomin, 16677 Suwon-si (KR); KIM, Minji, 16677 Suwon-si (KR); SEOL, Taejung, 16677 Suwon-si (KR); YANG, Jaebeom, 16677 Suwon-si (KR); LEE, Dalhee, 16677 Suwon-si (KR)
(74) Representative: Marks & Clerk LLP

(57) **Abstract**

A flip-flop includes a clock buffer that outputs, based on a clock signal, an inverted clock signal of the clock signal and a buffer clock signal obtained by delaying a phase of the clock signal, a master latch including a scan path and a data path, the data path receiving a data signal independently of the scan path, a slave latch that generates a first driving signal based on a first latch signal from the master latch and outputs an inverted output signal based on the first latch signal, the buffer clock signal, and the first driving signal, and an output driver that outputs an output signal based on the inverted output signal.

## Description

### BACKGROUND

Various embodiments relate to an electronic device, and more particularly, to a flip-flop for setting a negative setup time by reducing a setup time.

Flip-flops are general-purpose data storage elements used in digital electronic circuits. Flip-flops are clocked storage elements that enable a sequential and stable logic design, and flip-flops may store logic states, parameters, or digital control signals.

Microprocessors include a large number of flip-flops, and in order to perform high-performance microprocessor operations, it is advantageous to reduce a setup time and a hold time set for the flip-flops, and/or a clock-to-output time (or a CQ time). In general, a setup time is a time during which a logic level of a data should be maintained at a specific value before a rising edge of a clock.

Although a flip-flop including a multiplexer has been proposed to internalize a scan function, there is a disadvantage in that a path for sampling (or latching) a data signal in a master latch of the flip-flop is relatively long, which increases a setup time and thus decreases an overall operating speed of the flip-flop. Alternatively, although a flip-flop including a master latch that directly samples a data signal has been proposed to reduce a setup time, there is a limit to reducing the setup time.

### SUMMARY

It is an aspect to provide a flip-flop that reduces a setup time and that may allow for designing a circuit easily and flexibly.

According to an aspect of one or more embodiments, there is provided a flip-flop comprising a clock buffer configured to output, based on a clock signal, an inverted clock signal of the clock signal and a buffer clock signal obtained by delaying a phase of the clock signal; a master latch comprising a scan path and a data path, the data path being configured to receive a data signal independently of the scan path; a slave latch configured to generate a first driving signal based on a first latch signal from the master latch, the slave latch being configured to output an inverted output signal based on the first latch signal, the buffer clock signal, and the first driving signal; and an output driver configured to output an output signal based on the inverted output signal.

According to another aspect of one or more embodiments, there is provided a flip-flop comprising a clock buffer configured to output, based on a clock signal, an inverted clock signal of the clock signal, and a buffer clock signal obtained by delaying a phase of the clock signal; a master latch comprising a scan path and a data path, which are independent of each other, the master latch being configured to output a first latch signal having a second logic level that is lower than a first logic level for a data signal having the first logic level; a slave latch configured to generate a first driving signal having the first logic level based on the first latch signal, the slave latch being configured to output an inverted output signal having the second logic level in response to the first logic level of the first driving signal and a rising edge of the buffer clock signal; and an output driver configured to output an output signal having the first logic level based on the inverted output signal.

According to yet another aspect of one or more embodiments, there is provided a flip-flop comprising a clock buffer configured to output, based on a clock signal, an inverted clock signal of the clock signal, and a buffer clock signal obtained by delaying a phase of the clock signal; a master latch comprising a scan path and a data path, the scan path being configured to receive a scan enable signal and a scan input signal, and the data path being configured to receive a data signal independently of the scan path; a slave latch comprising a pull-up driver configured to pull up an inverted output signal based on a first latch signal of the master latch and the buffer clock signal, and a pull-down driver configured to pull down the inverted output signal based on the first latch signal and the inverted clock signal; and an output driver configured to output an output signal based on the inverted output signal.

At least some of the above and other features of the invention are set out in the claims.

### BRIEF DESCRIPTION OF THE DRAWINGS

Various embodiments will be more clearly understood from the following detailed description taken in conjunction with the accompanying drawings, in which:
FIG. 1 is a block diagram illustrating a flip-flop, according to an embodiment;
FIG. 2 is a circuit diagram illustrating the flip-flop of FIG. 1 in more detail, according to an embodiment;
FIG. 3 is a circuit diagram illustrating a flip-flop including an example of a slave latch of the flip-flop illustrated in FIG. 2, according to an embodiment;
FIGS. 4, 5, and 6 are diagrams for describing an operation of a flip-flop, according to an embodiment;
FIG. 7 is a timing diagram illustrating some signals, according to an embodiment;
FIG. 8 is a diagram for describing an operation of a flip-flop, according to an embodiment;
FIG. 9 is a circuit diagram illustrating a master latch, according to an embodiment;
FIGS. 10, 11, and 12 are circuit diagrams illustrating flip-flops, according to some embodiments;
FIG. 13 is a block diagram illustrating a flip-flop, according to an embodiment; and
FIG. 14 is a circuit diagram illustrating the flip-flop of FIG. 13 in more detail, according to an embodiment.

### DETAILED DESCRIPTION

Various embodiments will be described in detail with reference to the accompanying drawings.

As used in this specification, the terms "first" and "second" may modify various components regardless of order and/or importance and do not limit the components. These terms are only used to distinguish one component from another. For example, a "first" user device and a "second" user device may indicate different user devices from each other regardless of the order or importance of the devices. For example, a "first" component may be termed a "second" component, and similarly, a "second" component may be termed a "first" component without departing from the scope of the present disclosure.

In this specification, a "common node" refers to a point at which terminals of at least two components (e.g. at least two transistors) are connected to each other. For example, a common node between a first transistor and a second transistor may refer to a point at which a source of the first transistor and a drain of the second transistor are connected to each other, or a drain of the first transistor and a source of the second transistor are connected to each other.

In this specification, when a transistor is turned on, the turned-on transistor may electrically connect points connected to both terminals to each other. When a transistor is turned off, points connected to both terminals of the transistor may be electrically separated (e.g., electrically insulated) from each other.

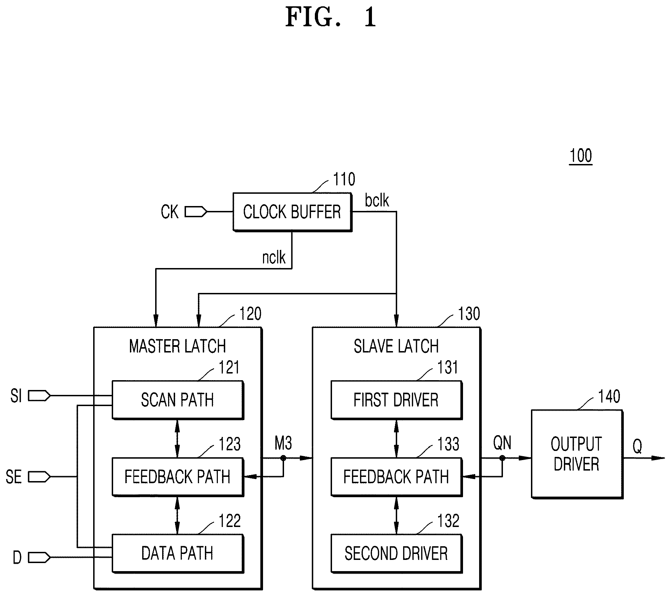

FIG. 1 is a block diagram illustrating a flip-flop 100, according to an embodiment.

Referring to FIG. 1, the flip-flop 100 may include a clock buffer 110, a master latch 120, a slave latch 130, and an output driver 140.

The clock buffer 110 may receive a clock signal CK. The clock signal CK may be generated by an external device (e.g., a clock generator or a clock management unit (CMU), etc.) outside the flip-flop 100. The clock buffer 110 may generate an inverted clock signal nclk and a buffer clock signal bclk based on the clock signal CK. The inverted clock signal nclk may be a signal having a phase opposite to a phase of the clock signal CK, that is, a signal obtained by inverting a phase of the clock signal CK (e.g., by inverting the clock signal CK). The buffer clock signal bclk may be a signal obtained by delaying a phase of the clock signal CK. The buffer clock signal bclk may be a signal obtained by inverting a phase of the inverted clock signal nclk (e.g., by inverting the inverted clock signal nclk). In some embodiments, the inverted clock signal nclk may be output to the master latch 120. In some embodiments, the inverted clock signal nclk may be provided to the slave latch 130. The buffer clock signal bclk may be output to each of the master latch 120 and the slave latch 130.

The master latch 120 may receive a data signal D, a scan enable signal SE, and a scan input signal SI. The scan enable signal SE may be a signal for enabling (or activating) or disabling (or deactivating) a scan operation on a semiconductor circuit (not shown). For example, when the scan enable signal SE has a first logic level (e.g., a logic high or a logic high level), a scan operation may be enabled. For example, when the scan enable signal SE has a second logic level opposite to the first logic level (e.g., a logic low or a logic low level), a scan operation may be disabled. The scan input signal SI may be a signal used to perform a scan operation. Although first and second logic levels are examples, for convenience of explanation, the following will be described assuming that the first logic level is a logic high level and the second logic level is a logic low level.

The master latch 120 may latch the data signal D or the scan input signal SI based on the inverted clock signal nclk and the buffer clock signal bclk, and may output a first latch signal M3 indicating a latched signal.

In an embodiment, the master latch 120 may include a scan path 121 and a data path 122 that are independent of each other. The master latch 120 according to an embodiment may further include a feedback path 123. When the scan path 121 and the data path 122 are independent of each other, the term "independent" may mean that the data signal D is input to the data path 122 independently of the scan path 121.

The scan path 121 may receive the scan enable signal SE and the scan input signal SI, and may output a scan path signal to the data path 122. When a logic level of the scan enable signal SE is the first logic level, the scan path 121 may invert the scan input signal SI. In an embodiment, the scan path 121 may include a scan multiplexer. In this case, the master latch 120 may be referred to as a master latch in which the scan multiplexer is incorporated. The data path 122 may receive the scan path signal, the scan enable signal SE, and the data signal D, may perform a logical operation on the data signal D and the scan path signal based on the inverted clock signal nclk and the buffer clock signal bclk, and may output the first latch signal M3. The feedback path 123 may feed back the first latch signal M3 of a previous stage to the master latch 120 based on the inverted clock signal nclk and the buffer clock signal bclk, and may hold the first latch signal M3 that is generated in the previous stage. A previous stage may be an earlier time (e.g., a previous time period, such as a previous phase of the clock signal). In an embodiment, the feedback path 123 may perform a feedback operation based on the inverted clock signal nclk and the buffer clock signal bclk.

The slave latch 130 may latch the first latch signal M3 based on the buffer clock signal bclk, and may output an inverted output signal QN indicating a latched signal. The inverted output signal QN may be a signal having a phase opposite to a phase of an output signal Q, that is, a signal obtained by inverting a phase of the output signal Q.

In an embodiment, the slave latch 130 may include a first driver 131 and a second driver 132. The slave latch 130 may further include a feedback path 133. The first driver 131 may generate a first driving signal based on the first latch signal M3, and may output the first driving signal to the second driver 132. The first driving signal may be a signal used to drive the inverted output signal QN. The second driver 132 may output the inverted output signal QN based on the first driving signal, the first latch signal M3, and the buffer clock signal bclk. The feedback path 133 may feed back a second latch signal of a previous stage to the slave latch 130 based on the buffer clock signal bclk, and may hold the second latch signal generated in the previous stage. The second latch signal may be a signal obtained by latching the inverted output signal QN based on the buffer clock signal bclk. In an embodiment, the feedback path 133 may perform a feedback operation based on the buffer clock signal bclk and a second driving signal CKB generated by the second driver 132. In an alternative embodiment, the feedback path 133 may perform a feedback operation based on the inverted clock signal nclk and the buffer clock signal bclk.

The output driver 140 may output the output signal Q based on the inverted output signal QN.

According to the above description, an operation of latching the data signal D may be performed at high speed, a setup time may be reduced, and power consumption may be reduced.

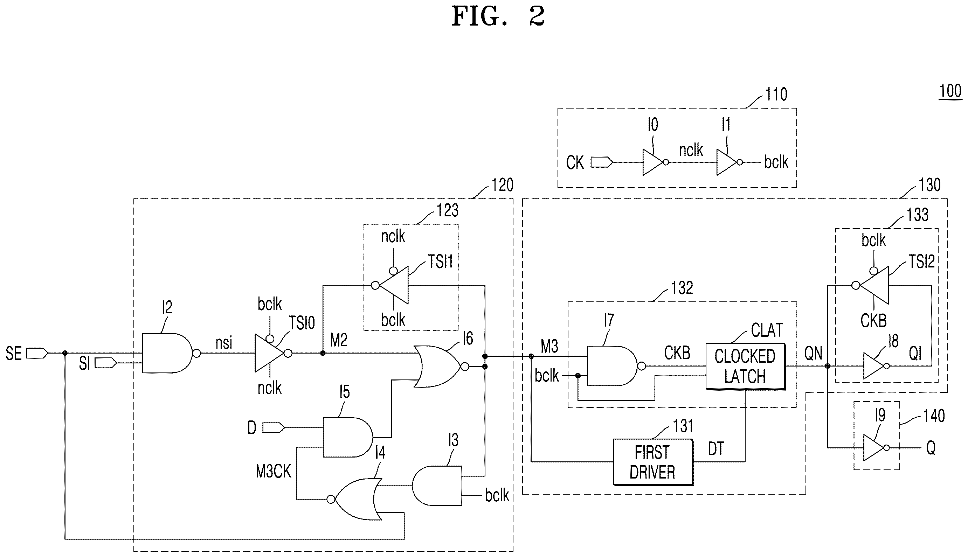

FIG. 2 is a circuit diagram illustrating the flip-flop 100 of FIG. 1 in more detail, according to an embodiment. In FIG. 2, the same description as that made with reference to FIG. 1 will be omitted for conciseness.

Referring to FIGS. 1 and 2, in an embodiment, the clock buffer 110 may include a plurality of inverters I0 and I1. The inverter I0 may invert the clock signal CK and may output the inverted clock signal nclk. In an embodiment, a time when the inverted clock signal nclk transitions and/or a time when an edge of the inverted clock signal nclk occurs may be the same as a time when the clock signal CK transitions and/or a time when an edge of the clock signal CK occurs. In some embodiments, a time when the inverted clock signal nclk transitions (and/or a time when an edge of the inverted clock signal nclk occurs) may be delayed compared to a time when the clock signal CK transitions (and/or a time when an edge of the clock signal CK occurs). The inverter I1 may invert the inverted clock signal nclk and may output the buffer clock signal bclk. In an embodiment, a time when the buffer signal bclk transitions may be delayed compared to a time when the clock signal CK transitions.

In an embodiment, the scan path 121 of the master latch 120 may include a NAND operator I2 and a tri-state inverter TSI0. A tri-state inverter may be a digital logic gate with three output states: high, low, and high-impedance. A tri-state inverter may function like a standard inverter, but with an additional enable input that controls whether the output is connected to the circuit (e.g., whether the tri-state inverter is in the high-impedance state). When enabled (e.g., when not in the high-impedance state), the output is the inverse of the input. While in a disabled state, the output enters a high-impedance state, effectively disconnecting it from the circuit. In some instances, an enable input and an inverted enable input are provided. The enable input may control an NMOS transistor in a pull-down network in the tri-state inverter and the inverted input may control PMOS transistor in a pull-up network in the tri-state inverter. A tri-state inverter may be otherwise known as an inverting tri-state digital buffer. The NAND operator I2 may perform a NAND operation on the scan enable signal SE and the scan input signal SI, and may output a scan signal nsi. The scan signal nsi may include a result of the NAND operation. The tri-state inverter TSI0 may receive the scan signal nsi, the inverted clock signal nclk, and the buffer clock signal bclk. The tri-state inverter TSI0 may output the scan signal nsi as a scan path signal M2, according to a logic level of each of the inverted clock signal nclk and the buffer clock signal bclk. The tri-state inverter TSI0 may invert the scan signal nsi and output the result of the inverter operation as a scan path signal M2, according to a logic level of each of the inverted clock signal nclk and the buffer clock signal bclk The inverted clock signal nclk and the buffer clock signal bclk may control when the tri-state inverter TSI0 is enabled and disabled. For instance, the inverted clock signal nclk may be input into the enable input of the tri-state inverter TSI0 and the buffer clock signal bclk may be input into the inverted enable input of the tri-state inverter TSI0.

The data path 122 of the master latch 120 may include a plurality of AND-OR-inverters (AOI) circuits. In an embodiment, one AOI circuit may be configured to perform the combination of an AND operation, an OR operation and an invert operation. In an embodiment, one AOI circuit may include one AND operator, one OR operator, and an inverter. In some embodiments, one AOI circuit may include one AND operator and one NOR operator. Referring to FIG. 2, for example, a first AOI circuit may include an AND operator I3 and a NOR operator I4, and a second AOI circuit may include an AND operator I5 and a NOR operator I6.

The first AOI circuit may output an internal clock signal M3CK based on the scan enable signal SE, the first latch signal M3, and the buffer clock signal bclk. In this case, the first latch signal M3 input to the first AOI circuit may be a signal whose operation has been completed in a previous stage. The AND operator I3 of the first AOI circuit may perform a first AND operation on the first latch signal M3 and the buffer clock signal bclk. The NOR operator I4 of the first AOI circuit may perform a first NOR operation on an output signal of the AND operator I3 indicating a result of the first AND operation and the scan enable signal SE. The NOR operator I4 may output the internal clock signal M3CK indicating a result of the first NOR operation.

The second AOI circuit may output the first latch signal M3 based on the scan path signal M2, the data signal D, and the internal clock signal M3CK. The AND operator I5 of the second AOI circuit may perform a second AND operation on the internal clock signal M3CK and the data signal D. The NOR operator I6 of the second AOI circuit may perform a second NOR operation on an output signal of the AND operator I5 indicating a result of the second AND operation and the scan path signal M2. The NOR operator I6 may output a result of the second NOR operation as the first latch signal M3 of a current stage.

The feedback path 123 of the master latch 120 may include a tri-state inverter TSI1. The tri-state inverter TSI1 may receive the first latch signal M3, the inverted clock signal nclk, and the buffer clock signal bclk. The tri-state inverter TSI1 may feed back the first latch signal M3 of the previous stage to an output terminal of the tri-state inverter TSI0 (and/or an input terminal of the NOR operator 16), according to a logic level of each of the inverted clock signal nclk and the buffer clock signal bclk. The tri-state inverter TSI1 may invert the first latch signal M3 and output the result of the inverter operation to the output terminal of the tri-state inverter TSIO, according to a logic level of each of the inverted clock signal nclk and the buffer clock signal bclk The inverted clock signal nclk and the buffer clock signal bclk may control when the tri-state inverter TSI1 is enabled and disabled. For instance, the buffer clock signal bclk may be input into the enable input of the tri-state inverter TSI1 and the inverted clock signal nclk may be input into the inverted enable input of the tri-state inverter TSI1.

A logic level of the first latch signal M3 of the current stage may be determined according to a logic level of each of the first latch signal M3 of the previous stage, the scan enable signal SE, the buffer clock signal bclk according to the clock signal CK, and the internal clock signal M3CK. For example, when a logic level of the scan enable signal SE is a logic low level, the data path 122 may be activated, and a logic level of the scan path signal M2 may be a logic low level. When logic levels of the first latch signal M3 of the previous stage, the scan enable signal SE, and the buffer clock signal bclk according to the clock signal CK are all logic low levels, a logic level of the internal clock signal M3CK may be a logic high level, and the inverted data signal D may be output as the first latch signal M3 of the current stage. Hereinafter, logic levels of the first latch signal M3 of the previous stage, the scan enable signal SE, and the buffer clock signal bclk according to the clock signal CK are respectively expressed as "[M3, SE, bclk, M3CK]=(0/1, 0/1, 0/1, 0/1)". In this case, when [M3, SE, bclk, M3CK]=(0, 0, 0, 1) or (1,0,0,1), the inverted data signal D may be output as the first latch signal M3 of the current stage. When [M3, SE, bclk, M3CK]=(0,0,1,1) or (1,0,1,0), the first latch signal M3 of the previous stage may be output. When a logic level of the scan enable signal SE is a logic high level, the data path 122 may be deactivated, and the scan input signal SI may be output as an output signal of the master latch 120. That is, [M3, SE, CK, M3CK]=(0,1,0,1), (0,1,1,0), (1,1,0,0), or (1,1,1,0).

According to the above description, because the scan path 121 and the data path 122 are independently separated by using the scan enable signal SE and the scan input signal SI for testing and debugging, unlike the data signal D, an operation of latching the data signal D may be performed at high speed.

Because a setup time of 0 or less is set by using the buffer clock signal bclk that is delayed more than the inverted clock signal nclk, the performance of the flip-flop 100 may be further improved.

In an embodiment, the slave latch 130 may be configured to generate a first driving signal DT based on the first latch signal M3. For example, the first driver 131 of the slave latch 130 may receive the first latch signal M3 and may output the first driving signal DT to the second driver 132 of the slave latch 130.

In an embodiment, the slave latch 130 may be configured to output the inverted output signal QN based on the first latch signal M3, the buffer clock signal bclk, and the first driving signal DT. For example, the second driver 132 may be configured to perform an operation on the first latch signal M3 and the buffer clock signal bclk. The second driver 132 may be configured to output the inverted output signal QN based on a second driving signal CKB corresponding to a result of the operation, the buffer clock signal bclk, and the first driving signal DT. The second driver 132 according to an embodiment may include a NAND operator I7 and a clocked latch CLAT. The NAND operator I7 may perform a NAND operation on the first latch signal M3 and the buffer clock signal bclk, and may output the second driving signal CKB to the clocked latch CLAT. The clocked latch CLAT may receive the first driving signal DT, the second driving signal CKB, and the buffer clock signal bclk, and may output the inverted output signal QN. For example, the clocked latch CLAT may be configured to output the inverted output signal QN having the first logic level in response to a falling edge of the second driving signal CKB. The clocked latch CLAT may be configured to output the inverted output signal QN having the second logic level in response to a rising edge of the first driving signal DT and a rising edge of the buffer clock signal bclk. The second logic level may be lower than the first logic level.

In an embodiment, the feedback path 133 of the slave latch 130 may be configured to perform a feedback operation based on the inverted output signal QN, the second driving signal CKB, and the buffer clock signal bclk. The feedback path 133 may include an inverter I8 and a tri-state inverter TSI2. The inverter I8 may invert the inverted output signal QN and may output a second latch signal QI. The tri-state inverter TSI2 may receive the second latch signal QI, the second driving signal CKB, and the buffer clock signal bclk. The tri-state inverter TSI2 may feed back the second latch signal QI to an output terminal of the clocked latch CLAT (and/or an input terminal of the inverter I8), according to a logic level of each of the second driving signal CKB and the buffer clock signal bclk. The tri-state inverter TSI2 may invert the second latch signal QI and output the result of the inverter operation to the output terminal of the clocked latch CLAT (and/or an input terminal of the inverter I8), according to a logic level of each of the second driving signal CKB and the buffer clock signal bclk. The second driving signal CKB and the buffer clock signal bclk may control when the tri-state inverter TSI2 is enabled and disabled. For instance, the second driving signal CKB may be input into the enable input of the tri-state inverter TSI2 and the buffer clock signal bclk may be input into the inverted enable input of the tri-state inverter TSI2.

In an embodiment, the output driver 140 may include an inverter I9. The inverter I9 may invert the inverted output signal QN and may output the output signal Q to the outside (e.g., to an external circuit).

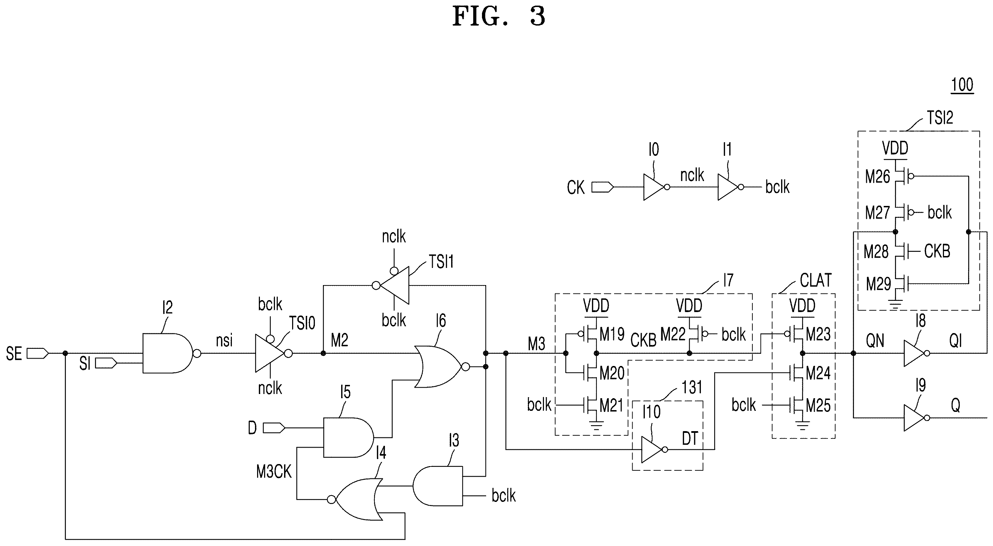

FIG. 3 is a circuit diagram illustrating the flip-flop 100 including an example of the slave latch 130 of FIG. 2, according to an embodiment. In FIG. 3, the same description as that made with reference to 2 will be omitted for conciseness.

Referring to FIGS. 2 and 3, the clock buffer 110 and the master latch 120 are the same as described with reference to FIG. 2. In an embodiment, the first driver 131 may include an inverter 110 including an input terminal for receiving the first latch signal M3 and an output terminal for outputting the first driving signal DT. The inverter I10 may invert the first latch signal M3 and may output the first driving signal DT. That is, the first driving signal DT according to an embodiment may be a signal obtained by inverting a phase of the first latch signal M3 (e.g., by inverting the first latch signal M3).

In an embodiment, the NAND operator I7 of the second driver 132 may include a plurality of P-type metal-oxide-semiconductor (PMOS) transistors M19 and M22 and a plurality of N-type metal-oxide-semiconductor (NMOS) transistors M20 and M21. The plurality of PMOS transistors M19 and M22 may be connected in parallel between a first power line to which a first supply voltage VDD is applied and an output terminal of the NAND operator 17. The PMOS transistor M19 and the plurality of NMOS transistors M20 and M21 may be connected in series between the first power line and a second power line of a second supply voltage (e.g., a voltage of ground). The first supply voltage VDD may be higher than the second supply voltage. The first latch signal M3 may be provided to a gate of each of the PMOS transistor M19 and the NMOS transistor M20. The buffer clock signal bclk may be provided to a gate of each of the NMOS transistor M21 and the PMOS transistor M22.

In an embodiment, the clocked latch CLAT of the second driver 132 may include a clocked complementary metal oxide semiconductor (CMOS) (C²MOS). The C²MOS may include a PMOS transistor M23 and a plurality of NMOS transistors M24 and M25. The transistors M23, M24, and M25 may be connected in series between the first power line and the second power line. The PMOS transistor M23 may be connected between the first power line and a first common node, and the second driving signal CKB may be provided to a gate of the PMOS transistor M23. The second driving signal CKB may be precharged to a logic high level H when a logic level of the buffer clock signal bclk is a logic low level L. The NMOS transistor M24 may be connected between the first common node and a second common node, and the first driving signal DT may be provided to a gate of the NMOS transistor M24. The NMOS transistor M25 may be connected between the second power line and the second common node, and the buffer clock signal bclk may be provided to a gate of the NMOS transistor M25.

In some embodiments, the clocked latch CLAT of the second driver 132 may be implemented as a tri-state inverter.

In an embodiment, the tri-state inverter TSI2 of the feedback path 133 may include a plurality of PMOS transistors M26 and M27 and a plurality of NMOS transistors M28 and M29 connected in series between the first power line and the second power line.

In an embodiment, a gate of each of the PMOS transistor M26 and the NMOS transistor M29 may be connected to an output terminal of the inverter I8, the buffer clock signal bclk may be provided to a gate of the PMOS transistor M27, the second driving signal CKB may be provided to a gate of the NMOS transistor M28, and one electrode of each of the PMOS transistor M27 and the NMOS transistor M28 may be connected to an output terminal of the clocked latch CLAT and an input terminal of the inverter I8. However, embodiments are not limited thereto, and in some embodiments, the arrangement and positions of the PMOS transistors M26 and M27 may be exchanged with each other, and the arrangement and positions of the NMOS transistors M28 and M29 may be exchanged with each other.

According to the above description, because the C²MOS is used to separate a clock-to-output path (or CQ path) into the PMOS transistor M23 and the plurality of NMOS transistors M24 and M25, the design of the flip-flop 100 may be facilitated.

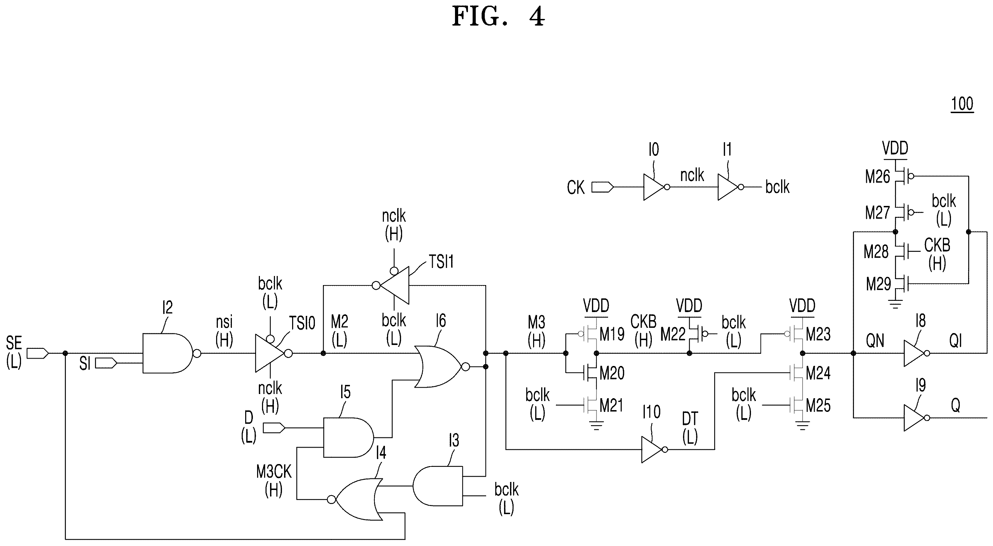

FIGS. 4, 5, and 6 are diagrams for describing an operation of the flip-flop 100 according to an embodiment. In detail, FIGS. 4, 5, and 6 are diagrams for describing an operation of latching the data signal D transitioning from the logic low level L to the logic high level H.

Referring to FIGS. 4, 5, and 6, the scan enable signal SE may have the logic low level L. In this case, a logic level of the scan signal nsi may be the logic high level H, and a logic level of the scan path signal M2 may be the logic low level L. In an embodiment, the master latch 120 may be configured to output the first latch signal M3 having the logic low level L in response to the data signal D having the logic high level H. The slave latch 130 may be configured to generate the first driving signal DT having the logic high level H based on the first latch signal M3, and may output the inverted output signal QN having the logic low level L in response to a rising edge of the buffer clock signal bclk and the first driving signal DT.

Referring to FIG. 4, because a logic level of the internal clock signal M3CK is the logic high level H when the clock signal CK has the logic low level L, the inverted data signal D may be output as the first latch signal M3. A logic level of the first latch signal M3 may be the logic high level H. In this case, the PMOS transistor M19 may be turned off, and the NMOS transistor M20 may be turned on. The buffer clock signal bclk may be the logic low level L, the NMOS transistors M21 and M25 may be turned off, and the PMOS transistor M22 may be turned on. When the PMOS transistor M22 is turned on, a logic level of the second driving signal CKB may be the logic high level H. In this case, the PMOS transistor M23 may be turned off. A logic level of the first driving signal DT may be the logic low level L. In this case, the NMOS transistor M24 may be turned on. The PMOS transistor M26 or the NMOS transistor M29 may be turned on according to a logic level of the second latch signal QI.

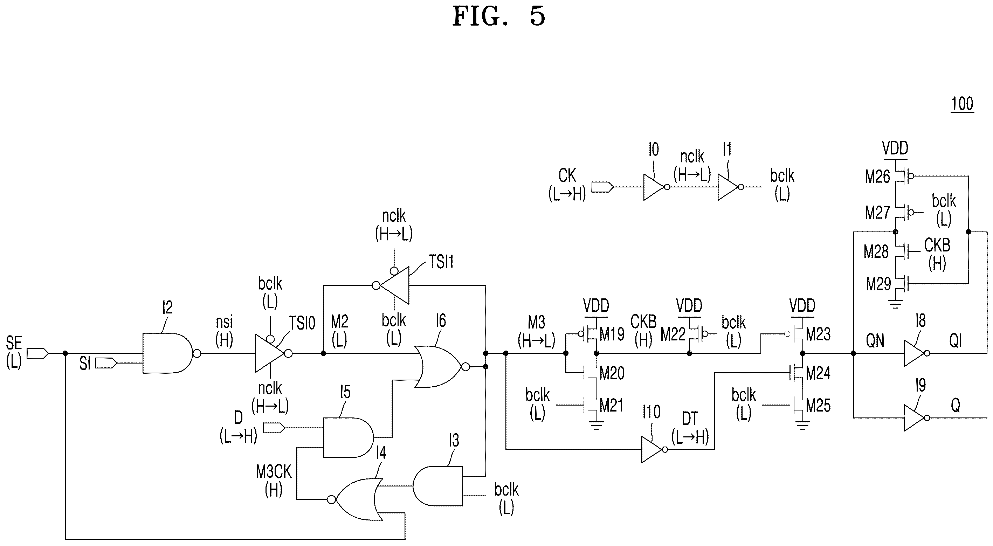

Referring to FIG. 5, a logic level of the clock signal CK may transition from the logic low level L to the logic high level H. That is, a rising edge of the clock signal CK may occur. As the rising edge of the clock signal CK occurs, a logic level of the inverted clock signal nclk may transition from the logic high level H to the logic low level L. A logic level of the data signal D may transition from the logic low level L to the logic high level H. In this case, a logic level of the first latch signal M3 may transition from the logic high level H to the logic low level L. Accordingly, the PMOS transistor M19 may be turned on, and the NMOS transistor M20 may be turned off. A logic level of the second driving signal CKB may be the logic high level H. A logic level of the first driving signal DT may transition from the logic low level L to the logic high level H. In this case, the NMOS transistor M24 may be turned on.

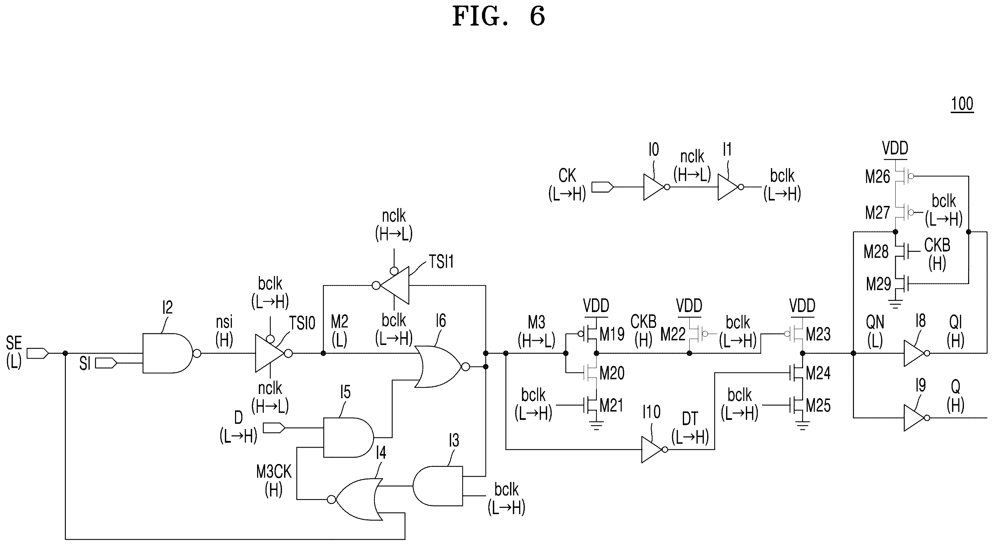

Referring to FIG. 6, a logic level of the buffer clock signal bclk may transition from the logic low level L to the logic high level H. In this case, the NMOS transistors M21 and M25 may be turned on, and the PMOS transistor M22 may be turned off. Due to the NMOS transistors M24 and M25 that are turned on, the second supply voltage of the second power line (e.g., the voltage of the ground) may be applied to a common node (e.g., an output terminal of the C²MOS) of the PMOS transistor M23 and the NMOS transistor M24. In this case, the inverted output signal QN may have the logic low level L. That is, the inverted output signal QN may be pull-down driven by the first driving signal DT and the buffer clock signal bclk. The second latch signal QI and the output signal Q may have the logic high level H, the PMOS transistors M26 and M27 may be turned off, and the NMOS transistors M28 and M29 may be turned on.

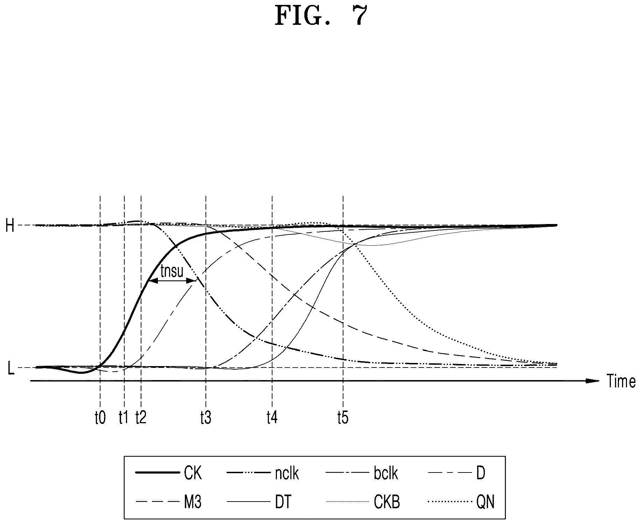

FIG. 7 is a timing diagram illustrating some signals CK, nclk, bclk, D, M3, DT, CKB, and QN, according to an embodiment. In detail, FIG. 7 is a timing diagram for latching the data signal D transitioning from the logic low level L to the logic high level H.

Referring to FIG. 7, when a rising edge of the clock signal CK occurs at time t0, a falling edge of the inverted clock signal nclk may occur at time t1. At time t2 after time t0, the data signal D may transition from the logic low level L to the logic high level H. At time t3, the first latch signal M3 may transition from the logic high level H to the logic low level L, and at time t4, the first driving signal DT may transition from the logic low level L to the logic high level H. When a rising edge of the buffer clock signal bclk occurs and the buffer clock signal bclk has the logic high level H at time t3 after time t0, the inverted output signal QN may transition from the logic high level H to the logic low level L at time t5. A logic level of the second driving signal CKB may generally maintain the logic high level H.

A setup time of 0 or more refers to a time for which a value (or a logic level) of the data signal D should be maintained immediately before a rising edge of the clock signal CK. When a setup time of 0 or more (hereinafter, a positive setup time) is set, the data signal D should maintain a transitioned logic level for the positive setup time or more before a rising edge of the clock signal CK occurs. Hence, for a high-speed operation, the performance of a flip-flop may increase as a setup time decreases. A setup time less than 0, that is, a negative setup time tnsu, may mean that the data signal D may be stably latched even when a value of the data signal D transitions after a rising edge of the clock signal CK. The first driving signal DT may have the logic high level H before the buffer clock signal bclk is completely pulled up (or before transition of the buffer clock signal bclk to the logic high level H is completed). Accordingly, flip-flops 100, 101, 102, 103, and 200 of various embodiments may accurately latch the data signal D even when a transition point of the data signal D occurs after a rising edge of the clock signal CK. That is, because the inverted output signal QN is driven by using the first and second driving signals DT and CKB and the buffer clock signal bclk, the negative setup time tnsu may be set to the flip-flops 100, 101, 102, 103, and 200 of various embodiments. Accordingly, high-speed operations of the flip-flops 100, 101, 102, 103, and 200 are possible, and the performance of the flip-flops 100, 101, 102, 103, and 200 may be improved.

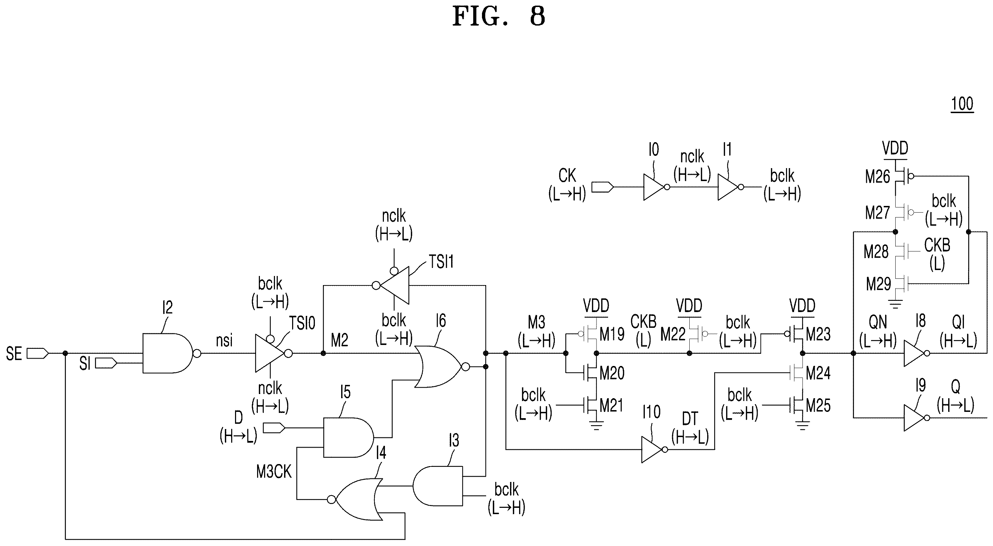

FIG. 8 is a diagram for describing an operation of the flip-flop 100 according to an embodiment. In FIG. 8, the same description as that made with reference to FIGS. 4, 5, and 6 will be omitted for conciseness.

Referring to FIG. 8, in an embodiment, the master latch 120 may be configured to output the first latch signal M3 having the logic high level H in response to the data signal D having the logic low level L. The slave latch 130 may output the inverted output signal QN having the logic high level H, in response to the first latch signal M3 having the logic high level H, the first driving signal DT having the logic low level L, and a rising edge of the buffer clock signal bclk.

For example, a logic level of the scan enable signal SE may be the logic low level L. When the data signal D transitions from the logic high level H to the logic low level L, the first latch signal M3 may transition from the logic low level L to the logic high level H, and the first driving signal DT may transition from the logic high level H to the logic low level L. In this case, the PMOS transistor M19 and the NMOS transistor M24 may be turned off, and the NMOS transistor M20 may be turned on. As a rising edge of the clock signal CK occurs, a logic level of the buffer clock signal bclk may transition from the logic low level L to the logic high level H. Accordingly, the PMOS transistor M27 may be turned off, and the NMOS transistors M21 and M25 may be turned on. Due to the NMOS transistors M20 and M21 that are turned on, the second driving signal CKB may have the logic low level L, the PMOS transistor M23 may be turned on, and the NMOS transistor M28 may be turned off. Due to the PMOS transistor M23 that is turned on, the inverted output signal QN may transition from the logic low level L to the logic high level H. That is, the inverted output signal QN may be pull-up driven by the first driving signal DT and the buffer clock signal bclk. The output signal Q and the second latch signal QI may transition from the logic high level H to the logic low level L.

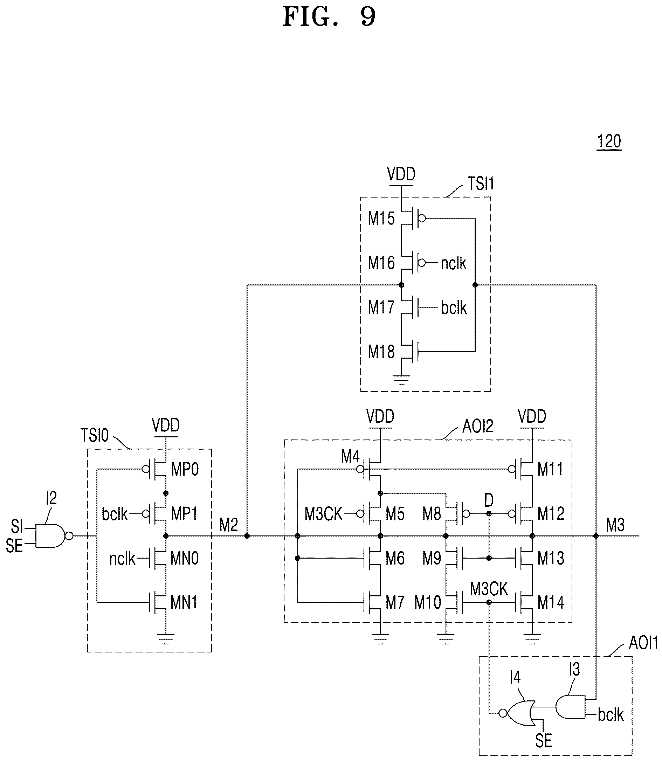

FIG. 9 is a circuit diagram illustrating the master latch 120, according to an embodiment. In FIG. 9, the same description as that made with reference to FIGS. 2 and 3 will be omitted for conciseness.

Referring to FIG. 9, the NAND operator I2 is the same as that described with reference to FIG. 2. The tri-state inverter TSI0 may include a plurality of PMOS transistors MP0 and MP1 and a plurality of NMOS transistors MN0 and MN1 connected in series between the first power line and the second power line. In an embodiment, a gate of each of the PMOS transistor MP0 and the NMOS transistor MN1 may be connected to an output terminal of the NAND operator I2. The buffer clock signal bclk may be provided to a gate of the PMOS transistor MP1, the inverted clock signal nclk may be provided to a gate of the NMOS transistor MN0, and a common node between the PMOS transistor MP1 and the NMOS transistor MN0 may be connected to an input terminal of the second AOI circuit AOI2. However, embodiments are not limited thereto, and in some embodiments, positions of the transistors MP0, MP1, MN0, and MN1 may be changed. For instance, the positions of transistors MP0 and MP1 may be swapped, and the positions of transistors MN0 and MN1 may be swapped.

The first AOI circuit AOI1 may include the AND operator I3 and the NOR operator I4. The second AOI circuit AOI2 may include a plurality of PMOS transistors M4, M5, M11, and M12 and a plurality of NMOS transistors M6, M7, M13, and M14. The transistors M4, M5, M6, and M7 may be connected in series between the first and second power lines. The transistors M11, M12, M13, and M14 may be connected in series between the first and second power lines. Transistors M8, M9, and M10 may be connected in series between a common node between the PMOS transistors M4 and M5 and the second power line. The scan path signal M2 may be provided to gates of the transistors M4, M6, M7, and M11. The internal clock signal M3CK may be provided to gates of the transistors M5, M10, and M14. The data signal D may be provided to gates of the transistors M8, M9, M12, and M13. The scan path signal M2 may be input to a common terminal of the transistors M5, M6, M8, M9, M12, and M13, and the first latch signal M3 may be output from the common terminal of the transistors M5, M6, M8, M9, M12, and M13.

The tri-state inverter TSI1 may include a plurality of PMOS transistors M15 and M16 and a plurality of NMOS transistors M17 and M18 connected in series between the first power line and the second power line. In an embodiment, the transistors M15, M16, M17, and M18 may be connected in series between the first and second power lines, gates of the transistors M15 and M18 may be connected to an output terminal of the master latch 120, and a common node between the transistors M16 and M17 may be connected to an output terminal of the tri-state inverter TSI0 and an input terminal of the second AOI circuit AOI2. The inverted clock signal nclk may be provided to a gate of the PMOS transistor M16, and the buffer clock signal bclk may be provided to a gate of the NMOS transistor M17. However, embodiments are not limited thereto, and in some embodiments, positions of the transistors MP0, MP1, MN0, and MN1 may be changed. For instance, the positions of transistors M15 and M16 may be swapped, and the positions of transistors M17 and M18 may be swapped.

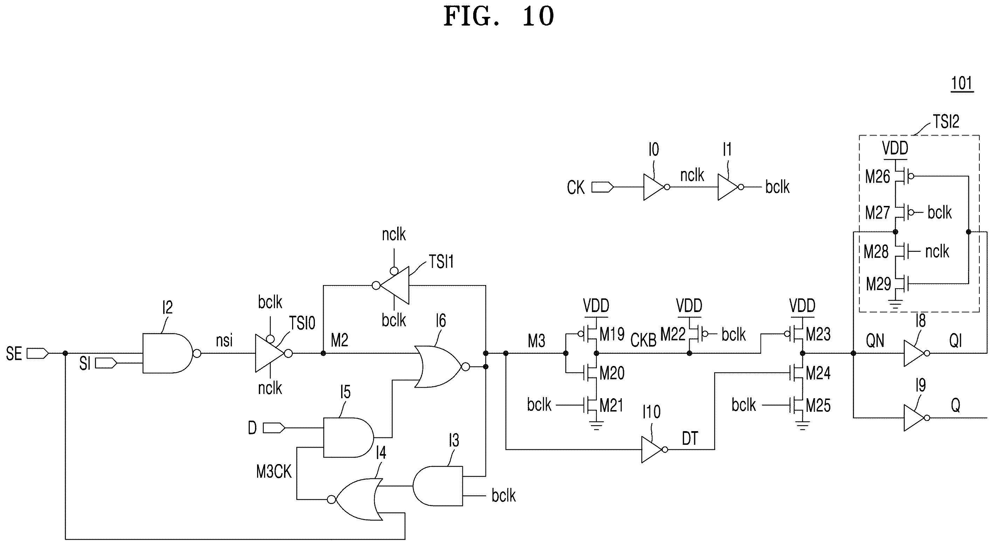

FIGS. 10, 11, and 12 are circuit diagrams illustrating the flip-flops 101, 102, and 103, according to some embodiments. In FIGS. 10, 11, and 12, the same description as that made with reference to FIGS. 2, 3, and 9 will be omitted for conciseness.

Referring to FIG. 10, in an embodiment, a slave latch of the flip-flop 101 may be configured to perform a feedback operation based on the inverted output signal QN, the inverted clock signal nclk, and the buffer clock signal bclk. For example, like the tri-state inverter TSI2 of FIG. 3, the tri-state inverter TSI2 of FIG. 10 may include a plurality of PMOS transistors M26 and M27 and a plurality of NMOS transistors M28 and M29 connected in series between the second power lines. However, unlike the tri-state inverter TSI2 of FIG. 3, the inverted clock signal nclk, instead of the second driving signal CKB, may be provided to a gate of the NMOS transistor M28. That is, unlike the tri-state inverter TSI2 of FIG. 3, the inverted clock signal nclk, may be provided to the enable input of the tri-state inverter TSI2 and the buffer clock signal bclk may be provided to the inverted enable input of the tri-state inverter TSI2.

According to the above embodiments, an operating speed of the flip-flop 101 may be further improved.

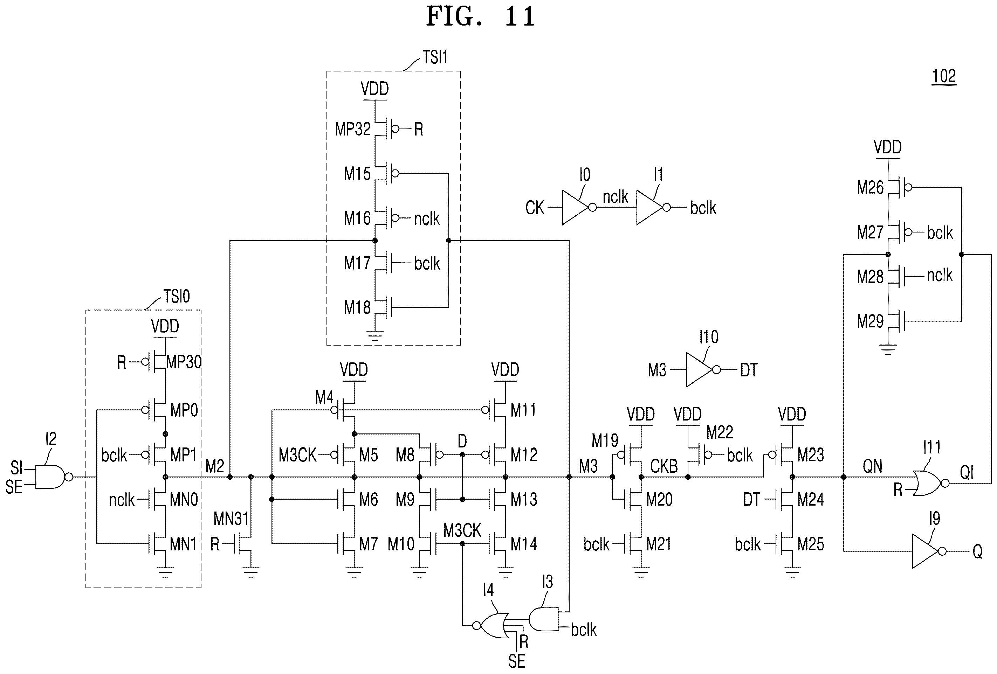

Referring to FIG. 11, in an embodiment, the flip-flop 102 may receive a reset signal R and may perform a reset operation based on the reset signal R. For example, the tri-state inverter TSI0 may further include a PMOS transistor MP30 connected in series to the PMOS transistor MP0. For example, an NMOS transistor MN31 connected between the second power line and a common node between the PMOS transistor MP1 and the NMOS transistor MN0 of the tri-state inverter TSI0 may be included. For example, the tri-state inverter TSI1 may further include a PMOS transistor MP32 connected in series to the PMOS transistor M15. The reset signal may be provided to gates of the PMOS transistors MP30 and MP32 and the NMOS transistor MN31. Like the NOR operator I4 of FIG. 10, the NOR operator I4 of FIG. 11 may include input terminals for receiving an output signal of the AND operator I3 and the scan enable signal SE. Unlike the NOR operator I4 of FIG. 10, the NOR operator I4 of FIG. 11 may further include an input terminal for receiving the reset signal R. A NOR operator I11, instead of the inverter I8 of FIG. 2, may be included in the flip-flop 102. The NOR operator I11 may perform a NOR operation on the inverted output signal QN and the reset signal R, and may output the second latch signal QI corresponding to a result of the NOR operation. For example, when a logic level of the reset signal R is the second logic level (e.g., the logic low level L), a logic level of the output signal Q may always be the second logic level.

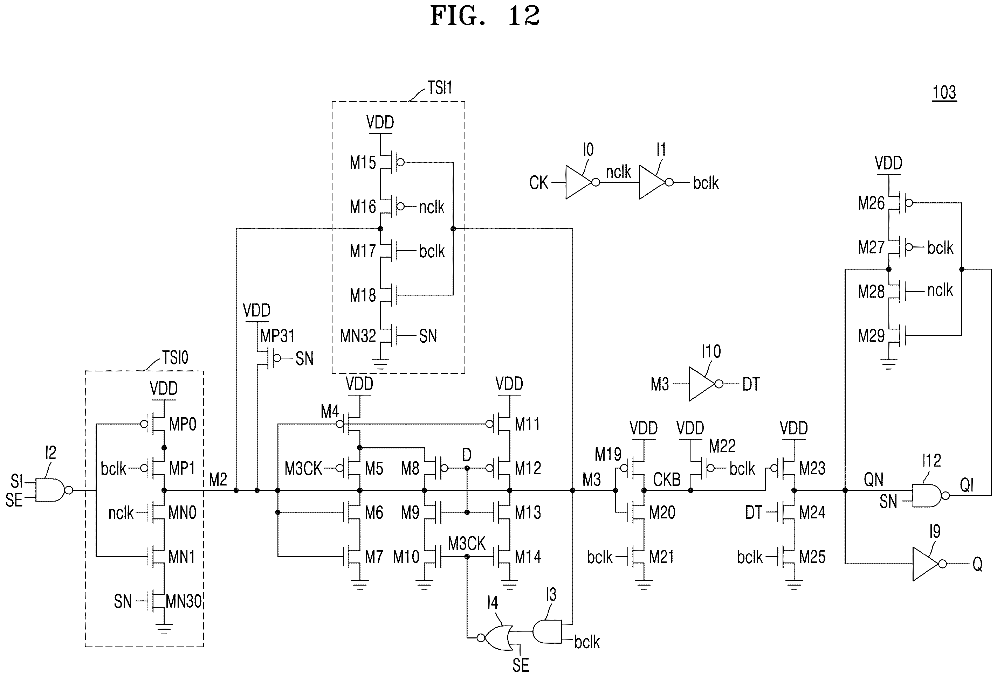

Referring to FIG. 12, in an embodiment, the flip-flop 103 may receive an inverted set signal SN of a set signal, and may perform a set operation based on the inverted set signal SN.

For example, the tri-state inverter TSI0 may further include an NMOS transistor MN30 connected in series to the NMOS transistor MN1. For example, a PMOS transistor MP31 connected between the first power line and a common node between the PMOS transistor MP1 and the NMOS transistor MN0 may be included. For example, the tri-state inverter TSI1 may further include an NMOS transistor MN32 connected in series to the NMOS transistor M18. The inverted set signal SN may be provided to gates of the transistors MN30, MP31, and MN32. A NAND operator I12, instead of the inverter I8 of FIG. 2, may be included in the flip-flop 103. The NAND operator I12 may perform a NAND operation on the inverted output signal QN and the inverted set signal SN, and may output the second latch signal QI corresponding to a result of the NAND operation. For example, when a logic level of the set signal is the logic high level H and a logic level of the inverted set signal SN is the logic low level L, a logic level of the output signal Q may always be the logic high level H.

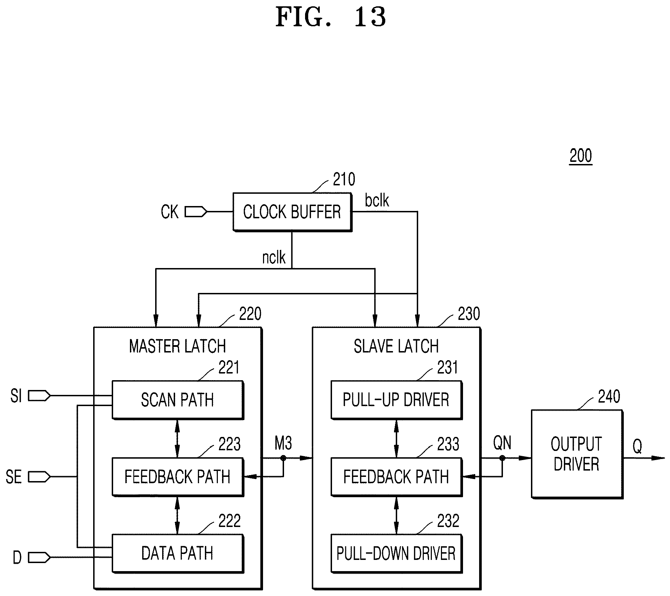

FIG. 13 is a block diagram illustrating the flip-flop 200, according to an embodiment. In FIG. 13, the same description as that made with reference to FIG. 1 will be omitted for conciseness.

Referring to FIG. 13, the flip-flop 200 may include a clock buffer 210, a master latch 220, a slave latch 230, and an output driver 240. The clock buffer 210, the master latch 220, and the output driver 240 may respectively be the same as the clock buffer 110, the master latch 120, and the output driver 140 of FIG. 1.

In an embodiment, the slave latch 230 may include a pull-up driver 231 and a pull-down driver 232. The pull-up driver 231 may be configured to pull up the inverted output signal QN based on the first latch signal M3 and the buffer clock signal bclk. The pull-down driver 232 may be configured to pull down the inverted output signal QN based on the first latch signal M3 and the inverted clock signal nclk.

The slave latch 230 may further include a feedback path 233. In an embodiment, the feedback path 233 may be configured to perform a feedback operation based on the inverted output signal QN, the inverted clock signal nclk, and the buffer clock signal bclk. In some embodiments, the feedback path 233 may be configured to perform a feedback operation based on the inverted output signal QN, the second driving signal CKB, and the buffer clock signal bclk.

According to the above description, an operation of latching the data signal D may be performed at high speed, and a setup time may be reduced.

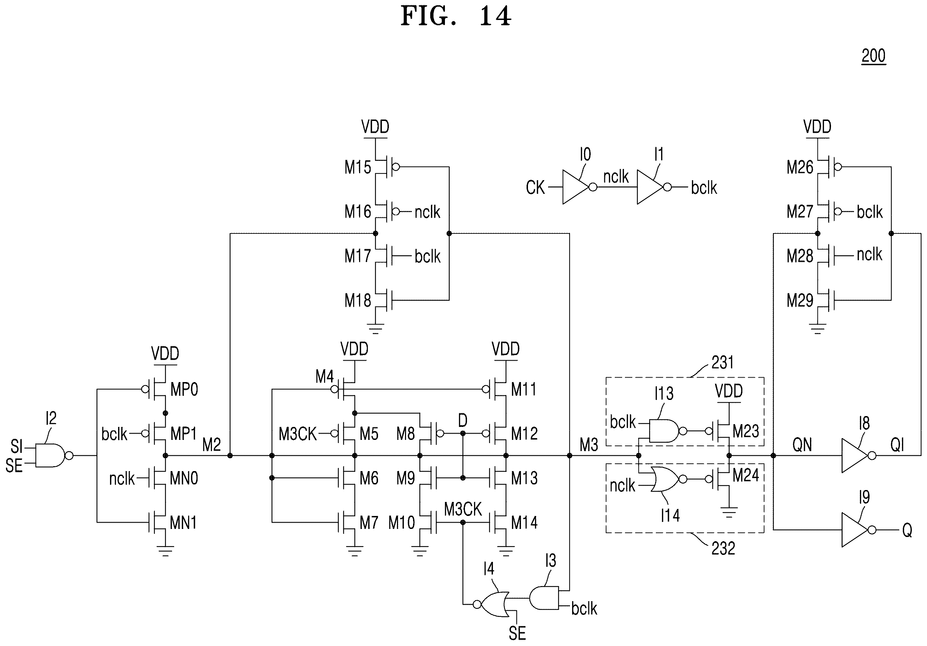

FIG. 14 is a circuit diagram illustrating the flip-flop 200 of FIG. 13 in more detail, according to an embodiment. In FIG. 14, the same description as that made with reference to FIGS. 2, 3, 9, and 10 will be omitted for conciseness.

Referring to FIG. 14, the scan path 221, the data path 222, and the feedback path 223 of FIG. 13 may include components as described with reference to FIG. 9.

The pull-up driver 231 of FIG. 13 may include a NAND operator I13 and the PMOS transistor M23. The NAND operator I13 may perform a NAND operation on the first latch signal M3 and the buffer clock signal bclk. The PMOS transistor M23 may be connected between the first power line and a common node, and may include a gate electrode connected to an output terminal of the NAND operator I13. The pull-up driver 231 of FIG. 13 according to an embodiment may include the PMOS transistors M19 and M22, the NMOS transistors M20 and M21, and the PMOS transistor M23 configured to pull up the inverted output signal QN.

The pull-down driver 232 of FIG. 13 may include a NOR operator I14 and the NMOS transistor M24. The NOR operator I14 may perform a NOR operation on the first latch signal M3 and the inverted clock signal nclk. The NMOS transistor M24 may be connected between the second power line and a common node of the PMOS transistor M23, and may include a gate electrode connected to an output terminal of the NOR operator I14. The pull-down driver 232 of FIG. 13 according to an embodiment includes one stack of NMOS transistors M24, instead of the NMOS transistors M24 and M25 configured to pull down the inverted output signal QN, and includes the NOR operator I14 for receiving the first latch signal M3 and the inverted clock signal nclk instead of the inverter I10.

While various embodiments have been described using specific terms, these terms are only used for the purpose of explaining the technical idea of the present disclosure and are not used to limit the meaning and scope of the appended claims. Hence, it will be understood by one of ordinary skill in the art that various modifications and other equivalent embodiments may be made therefrom. Accordingly, the technical scope of the present disclosure should be defined by the following claims.

While various embodiments have been particularly shown and described with reference to the drawings, it will be understood that various changes in form and details may be made therein without departing from the scope of the following claims.

## Claims

1. A flip-flop comprising:
a clock buffer (110) configured to output, based on a clock signal, an inverted clock signal of the clock signal and a buffer clock signal obtained by delaying a phase of the clock signal;
a master latch (120) comprising a scan path (121) and a data path (122), the data path (122) being configured to receive a data signal independently of the scan path (121);
a slave latch (130) configured to generate a first driving signal based on a first latch signal from the master latch (120), the slave latch (130) being configured to output an inverted output signal based on the first latch signal, the buffer clock signal, and the first driving signal; and
an output driver (140) configured to output an output signal based on the inverted output signal.

2. The flip-flop of claim 1, wherein the slave latch (130) comprises:
a first driver (131) configured to invert the first latch signal, the first driver (131) being configured to output an inverted first latch signal as the first driving signal; and
a second driver (132) configured to perform an operation on the first latch signal and the buffer clock signal, the second driver (132) being configured to output the inverted output signal based on the buffer clock signal, the first driving signal, and a second driving signal that corresponds to a result of the operation.

3. The flip-flop of claim 2, wherein the first driver (131) comprises an inverter (I10) comprising an input terminal configured to receive the first latch signal and an output terminal configured to output the first driving signal.

4. The flip-flop of claim 2 or claim 3, wherein the second driver (132) comprises:
a NAND operator (I7) configured to perform a NAND operation on the first latch signal and the buffer clock signal, the NAND operator (I7) being configured output the second driving signal; and
a clocked latch (CLAT) configured to output the inverted output signal having a first logic level in response to a falling edge of the second driving signal, the clocked latch (CLAT) being configured to output the inverted output signal having a second logic level that is lower than the first logic level in response to a rising edge of the first driving signal and a rising edge of the buffer clock signal.

5. The flip-flop of claim 4, wherein the clocked latch (CLAT) comprises:
a first transistor (M23) connected between a first power line to which a first supply voltage is applied and a first common node, the first transistor (M23) comprising a gate that receives the second driving signal;
a second transistor (M24) connected between the first common node and a second common node, the second transistor (M24) comprising a gate that receives the first driving signal; and
a third transistor (M25) connected between a second power line to which a second supply voltage is applied and the second common node, the third transistor (M25) comprising a gate that receives the buffer clock signal.

6. The flip-flop of any of claims 2-5, wherein the slave latch (130) further comprises a feedback path (133) configured to perform a feedback operation based on the inverted output signal, the second driving signal, and the buffer clock signal.

7. The flip-flop of any of claims 1-5, wherein the slave latch (130) further comprises a feedback path (133) configured to perform a feedback operation based on the inverted output signal, the inverted clock signal, and the buffer clock signal.

8. The flip-flop of claim 7, wherein the scan path (121) and the data path (122) are configured to receive a reset signal,
wherein the feedback path (133) comprises:
a NOR operator (I11) configured to perform a NOR operation on the inverted output signal and the reset signal, the NOR operator (I11) being configured to output a second latch signal corresponding to a result of the NOR operation; and
a tri-state inverter (TSI2) configured to feed back the second latch signal of a previous stage to an input terminal of the NOR operator (I11), according to a logic level of each of the inverted clock signal and the buffer clock signal.

9. The flip-flop of claim 7, wherein the scan path (121) and the data path (122) are configured to receive an inverted set signal of a set signal,
wherein the feedback path (133) comprises:
a NAND operator (I12) configured to perform a NAND operation on the inverted output signal and the inverted set signal, the NAND operator (I12) being configured to output a second latch signal corresponding to a result of the NAND operation; and
a tri-state inverter (TSI2) configured to feed back the second latch signal of a previous stage to an input terminal of the NAND operator (I12), according to a logic level of each of the inverted clock signal and the buffer clock signal.

10. A flip-flop according to any preceding claim, wherein:
the scan path (121) and the data path (122) are independent of each other;
the master latch (120) is configured to output the first latch signal having a second logic level that is lower than a first logic level for a data signal having the first logic level;
the slave latch (130) is configured to generate the first driving signal having the first logic level based on the first latch signal, the slave latch being (130) configured to output the inverted output signal having the second logic level in response to the first logic level of the first driving signal and a rising edge of the buffer clock signal; and
the output driver (140) is configured to output the output signal having the first logic level based on the inverted output signal.

11. The flip-flop of claim 10, when dependent on any of claims 1-3, wherein the slave latch (130) comprises:
a NAND operator (I7) configured to perform a NAND operation on the first latch signal and the buffer clock signal, the NAND operator (I7) being configured to output a second driving signal having the first logic level;
a clocked latch (CLAT) configured to output the inverted output signal having the second logic level, in response to the first logic level of the first driving signal, the first logic level of the second driving signal, and the rising edge of the buffer clock signal;
an inverter (I8) configured to invert the inverted output signal; and
a tri-state inverter (TSI2) configured to feed back a second latch signal of the inverter (I8) to an output terminal of the clocked latch (CLAT), based on the buffer clock signal and the second driving signal.

12. The flip-flop of claim 10, when dependent on any of claims 1-3, wherein the slave latch (130) comprises:
a NAND operator (I7) configured to perform a NAND operation on the first latch signal and the buffer clock signal, the NAND operator (I7) being configured to output a second driving signal having the first logic level;
a clocked latch (CLAT) configured to output the inverted output signal having the second logic level, in response to the first logic level of the first driving signal, the first logic level of the second driving signal, and the rising edge of the buffer clock signal;
an inverter (I8) configured to invert the inverted output signal; and
a tri-state inverter (TSI2) configured to feed back a second latch signal of the inverter to an output terminal of the clocked latch (CLAT), based on the inverted clock signal and the buffer clock signal.

13. The flip-flop of claim 11 or claim 12, wherein the clocked latch (CLAT) comprises:
a first transistor (M23) connected between a first power line to which a first supply voltage is applied and a first common node, the first transistor (M23) comprising a gate that receives the second driving signal;
a second transistor (M24) connected between the first common node and a second common node, the second transistor (M24) comprising a gate that receives the first driving signal; and
a third transistor (M25) connected between a second power line to which a second supply voltage is applied and the second common node, the third transistor (M25) comprising a gate that receives the buffer clock signal.

14. The flip-flop of claim 10, when dependent on any of claims 1-3, wherein
the scan path (121) and the data path (122) are configured to receive a reset signal, and
the slave latch (130) further comprises a feedback path (133),
wherein the feedback path (133) comprises:
a NOR operator (I11) configured to perform a NOR operation on the inverted output signal and the reset signal, the NOR operator (I11) being configured to output a second latch signal corresponding to a result of the NOR operation; and
a tri-state inverter (TSI2) configured to feed back the second latch signal of a previous stage to an input terminal of the NOR operator (I11), according to a logic level of each of the inverted clock signal and the buffer clock signal.

15. The flip-flop of claim 10, when dependent on any of claims 1-3, wherein
the scan path (121) and the data path (122) are configured to receive an inverted set signal of a set signal, and
the slave latch (130) further comprises a feedback path (133),
wherein the feedback path (133) comprises:
a NAND operator (I12) configured to perform a NAND operation on the inverted output signal and the inverted set signal, the NAND operator (112) being configured to output a second latch signal corresponding to a result of the NAND operation; and
a tri-state inverter (TSI2) configured to feed back the second latch signal of a previous stage to an input terminal of the NAND operator (I12), according to a logic level of each of the inverted clock signal and the buffer clock signal.
